# EUROPÄISCHE PATENTSCHRIFT

(11) **EP 0 565 069 B1**
(45) Veröffentlichungstag und Bekanntmachung des Hinweises auf die Patenterteilung: **26.06.1996**
(21) Anmeldenummer: 93105722.8
(22) Anmeldetag: 07.04.1993
(51) Int. Cl.: G02B 5/00, H01J 37/09, G01J 3/04, G21K 1/04

(54) **Verstellbare Blende und Verfahren zu ihrer Herstellung**
Adjustable diaphragm and manufacturing process
Diaphragma adjustable et procédé de fabrication

(30) Priorität: 10.04.1992 DE 4212077
(43) Veröffentlichungstag der Anmeldung: 13.10.1993
(73) Patentinhaber: FRAUNHOFER-GESELLSCHAFT ZUR FÖRDERUNG DER ANGEWANDTEN FORSCHUNG E.V., D-80636 München (DE)
(72) Erfinder: Wehrsdorfer, Eike, O-6520 Eisenberg (DE); Fuchs, Jörg, Dr., O-6902 Jena (DE); Karthe, Wolfgang, Prof., O-6902 Jena (DE); Martin,Thomas, O-6901 Stiebritz (DE)

(56) Entgegenhaltungen:
- EP-A- 0 276 337
- EP-A- 0 280 375
- EP-A- 0 344 515
- DE-A- 4 110 839

## Beschreibung

Die Erfindung betrifft eine verstellbare Blende nach dem Oberbegriff der Ansprüche 1 und 2. Sie besteht aus zwei um ihre Mitte drehbar gelagerten ersten Schenkeln sowie zwei zweiten Schenkeln, die mit den ersten Schenkeln unter Bildung eines Parallelogramms bewegbar verbunden sind und die jeweils eine Spaltschneide eines Spaltschneidenpaares tragen, sowie aus einer Betätigungseinrichtung mittels der die Form des Parallelogramms gegen die Wirkung einer Rückstellkraft und damit der Abstand der Spaltschneiden veränderbar ist.

Die Erfindung bezieht sich ferner auf ein Verfahren zur Herstellung einer solchen Blende.

Eine verstellbare Blende der eingangs genannten Art, bei der zwei Blendenplatten bzw. Spaltschneiden über eine Parallelogrammführung bewegt werden, ist aus der US-PS 2,964,998 bekannt. Bei dieser Blende sind jeweils die benachbarten Schenkel mit Hilfe von Drehzapfen bewegbar verbunden. Auch die mittige Lagerung der ersten beiden Schenkel am mit einem Fenster versehenen Gehäuse erfolgt mittels Drehzapfen. Als Betätigungseinrichtung dient eine von Hand verstellbare, auf das eine Ende einer der die Spaltschneiden tragenden Schenkel wirkende Mikrometerschraube. Die Rückstellkraft wird von einer auf das andere Ende dieses Schenkels wirkenden Feder aufgebracht.

Da das Parallelogramm aus einzelnen zu fertigenden Teilen zusammengesetzt ist, bleibt die erreichbare Präzision, insbesondere was die Symmetrie der Bewegung der Blendenplatten bzw. Spaltschneiden anbelangt, begrenzt, denn sowohl bei der Fertigung als auch beim Zusammensetzen dieser Teile muß mit Längendifferenzen gerechnet werden, was zwangsläufig Führungsfehler zur Folge hat. Auch der Spaltkeilwinkel ist bei dieser Blende verhältnismäßig groß, da die Spaltschneiden einzeln durch Schweißen befestigt werden.

Der Erfindung liegt daher die Aufgabe zugrunde, eine verstellbare Blende der eingangs genannten Art zu schaffen, die einerseits in ihrem Aufbau möglichst unkompliziert ist, andererseits aber auch eine hochpräzise Verstellbarkeit, insbesondere symmetrische Bewegung der Spaltschneiden zuläßt.

Die prinzipielle Lösung soll sowohl für variable Spalte als auch für variable Pinholes gleichermaßen geeignet sein.

Der Erfindung liegt ferner die Aufgabe zugrunde, ein Verfahren zur Herstellung einer solchen Blende anzugeben. Für hochpräzise Anwendungen soll dabei das Problem gelöst werden, daß neben der Gewährleistung einer präzisen Verstellbarkeit auch die Spaltschneiden bzw. Pinholes mit höchster reproduzierbarer Güte bezüglich der geometrischen Abmessungen und der Oberflächengestalt, insbesondere mit einer extrem geringen Kantenrauhigkeit der Schneiden bzw. Pinholes hergestellt werden können. Dabei soll die bisherige aufwendige handwerkliche Fertigung durch einen technologisch beherrschbaren industriellen und vergleichsweise kostengünstigen Prozeß abgelöst werden.

Die Ansprüche 1 und 2 beschreiben erfindungsgemäße Lö sungen:
- Die vorgenannte Aufgabe wird erfindungsgemäß dadurch gelöst, daß die Betätigungseinrichtung aus einem Piezoaktuator besteht, der zwischen den ersten beiden Schenkeln seitlich beabstandet von den Lagerpunkten dieser Schenkel angeordnet ist, und daß benachbarte erste und zweite Schenkel über Festkörperfedergelenke miteinander verbunden sind, wobei sämtliche Gelenkpunkte des einen der ersten Schenkel gegenüber denjenigen des anderen ersten Schenkels quer zur Bewegungsrichtung des Piezoaktuators um einen Betrag V versetzt sind.
- Die Aufgabe wird ebenso erfindungsgemäß dadurch gelöst, daß die Betätigungseinrichtung aus einem Piezoaktuator besteht, der zwischen den ersten beiden Schenkeln schräg angeordnet ist, indem eine der beiden Endflächen des Piezoaktuators gegenüber der anderen Endfläche am jeweiligen Schenkel im Abstand von dessen Lagerpunkt um einen Betrag V versetzt angreift, und daß benachbarte erste und zweite Schenkel über Festkörperfedergelenke miteinander verbunden sind.

Eine bevorzugte Ausführungsform der Erfindung besteht darin, daß der Piezoaktuator mit seinen Endflächen auf Aufnahmetellern aufliegt, welche jeweils über ein Gelenk mit einem der ersten Schenkel verbunden sind. Hierdurch werden die mit den Längenänderungen des Piezoaktuators einhergehenden Drehbewegungen ausgeglichen, die durch die Parallelogrammbewegung entstehen.

Für Pinholeanwendungen ist es günstig, wenn jede der Spaltschneiden mit zumindest zwei im Winkel zueinander stehenden Schneidkanten versehen ist. Eine bevorzugte Ausbildungsform sieht hier vor, daß die Schneidkanten einer jeden Spaltschneide eine rechteckige Öffnung bilden. Im Zusammenwirken beider Spaltschneiden können somit variable rechteckige oder speziell quadratische Öffnungsgeometrien der Pinholes realisiert werden. Wenn eine der beiden eine rechteckige Öffnung aufweisenden Spaltschneiden um einen Winkel verdreht auf dem zweiten Schenke angeordnet ist, kann im Zusammenwirken dieser Spaltschneiden auch ein variables dreieckförmiges Pinhole gebildet werden.

Eine besonders vorteilhafte Ausführungsform der Erfindung ist auch dadurch gegeben, daß die Spaltschneiden aus einem naß- oder trockenätzbaren, einkristallinen Material bestehen und entlang einer ausgewählten Kristallgitterrichtung verlaufende Schneidkanten aufweisen. Hierdurch wird eine extrem niedrige Rauhigkeit der Schneidkanten erreicht.

Vorzugsweise sind die Spaltschneiden aus einkristallinem Silizium gefertigt.

Die Wirkfläche der Spaltschneiden, insbesondere die Schneidkanten der Spaltschneiden, kann mit einem Metall-, Kunststoff- oder Keramiküberzug versehen sein, um die physikalischen und chemischen Eigenschaffen der Spaltschneiden optimal dem zu regulierenden Medium anzupassen. So ist es beispielsweise möglich, mit einer dämpfenden, der verwendeten Wellenlänge angepaßten Beschichtung Reflexionen elektromagnetischer Strahlung oder Materialfluoreszenz zu vermeiden.

Eine andere vorzugsweise Ausführungsform sieht vor, daß zur Messung der Spaltweite ein Wegmeßsystem angeordnet ist. Mit Hilfe der gemessenen IST-Spaltweite kann über einen Regelkreis die Spannung am Piezoaktuator entsprechend einer Soll-Spaltweite eingestellt werden. Hierdurch wird eine Linearisierung der Verstellbewegung möglich. Auch Längenänderungen aufgrund von Temperaturschwankungen der Umgebung können so ausgeglichen werden.

Eine besondere Ausbildungsform besteht auch darin, daß mehrere, jeweils mit einer Spaltstelleinrichtung versehene Spaltschneidenpaare in Ebenen parallel zueinander derart übereinander gestapelt sind, daß im Zusammenwirken der Spaltstelleinrichtungen eine gewünschte Öffnungsgeometrie, z.B. ein 8-Eck, entsteht.

Das Verfahren zur Herstellung einer piezoelektrisch verstellbaren Blende, die aus einer Spalt-Stelleinrichtung mit einem Piezoaktuator und mindestens einem Spaltschneidenpaar besteht, zeichnet sich erfindungsgemäß dadurch aus, daß zunächst zumindest zwei durch Stege miteinander verbundene Spaltschneiden hergestellt werden, wobei die Kontur der Spaltschneiden mittels Mikrolitographie in eine sich auf einem Wafer befindende Resistmaske geschrieben und mittels mindestens eines Ätzprozesses in den Wafer übertragen wird, daß ferner ein aus zwei ersten gegenüberliegenden Schenkeln und zwei zweiten gegenüberliegenden Schenkeln bestehendes, durch vier Federgelenke miteinander verbundenes Festkörperfedergelenk-Parallelogramm vorgefertigt wird, dessen erste Schenkel mittels Gelenken in einer Befestigungsplatte drehbar gelagert sind, und daß sodann der Piezoaktuator außermittig zwischen den ersten Schenkeln angeordnet wird und daß danach die durch Stege verbundenen Spaltschneiden zunächst als einteiliges Spaltschneidenpaar auf den zweiten Schenkeln montiert werden und daß nach Herstellung der festen Verbindung zwischen Spaltschneidenpaar und Spalt-Stelleinrichtung durch erstmaliges Auslenken des Piezoaktuators das Spaltschneidenpaar durch Brechen der Stege in die Spaltschneiden vereinzelt wird. Vorzugsweise wird als Material für den Wafer einkristallines Silizium verwendet.

Die Lage der Struktur einer Nutzstrukturmaske zur Kristallorientierung des Materials des Wafers wird in vorteilhafter Weise dadurch bestimmt, daß zunächst mit Hilfe von Justiermarken eine Probeätzung durchgeführt, das Ergebnis nach Symmetriemerkmalen beurteilt und danach die Lage der Nutzstrukturmaske zu einer ausgewählten Kristallgitterrichtung des Wafers ausgerichtet wird. Hierdurch werden Genauigkeiten von kleiner 0,002° Abweichung erreicht. Vorzugsweise wird die Nutzstrukturmaske zum Wafer dabei so ausgerichtet, daß eine Kristallgitterrichtung des Materials, welche die Spur einer die Waferoberfläche schneidende [111]-Fläche ist, mit der Richtung einer Schneidkante der Spaltschneide weitestgehend übereinstimmt.

Eine vorteilhafte Weiterbildung des ertindungsgemäßen Verfahrens besteht auch darin, daß das Festkörperfedergelenk-Parallelogramm aus einem Stück eines massiven, elektrisch leiffähigen Materials durch Elektroerosion gefertigt wird. Hierdurch werden eine hohe Präzision der Kontur und dünne gut reproduzierbare Materialstärken, insbesondere an den Federgelenken, gewährleistet. Vorzugsweise wird das Festkörperfedergelenk-Parallelogramm aus Edelstahl gefertigt.

Günstig zur Gewährleistung einer hohen Präzision ist es auch, wenn auf den zweiten Schenkeln des Festkörperfedergelenk-Parallelogramms zunächst vorgefertigte, mit Montageflächen für die Spaltschneiden versehene Spaltschneidenträger befestigt werden, anschließend Planparallelität der Montageflächen durch wenigstens einen Schleifvorgang hergestellt wird und erst danach die Spaltschneiden auf den Montageflächen montiert werden.

Vorzugsweise werden die Spaltschneiden durch Aufkleben befestigt.

Mit dem erfindungsgemäßen Verfahren gelingt es, eine extrem genau verstellbare Blende mit einem sehr homogenen (Licht-) Spalt herzustellen. Technisch sicher beherrschbar sind Rauhigkeiten von 50 nm bei den Schneidenkanten und auf 10 mm Spaltlänge 200 nm Abweichung von der Parallelen.

Es ist zwar eine kontinuierlich einstellbare Mikroblende bekannt, deren Antrieb piezoelektrisch erfolgt (US-PS 4,880,294), zur Übertragung der Bewegung auf die Blendenplattenpaare bzw. Spaltschneiden dient hierbei jedoch ein im Vergleich zum Erfindungsgegenstand wesentlich komplizierteres, weil eine Vielzahl von Hebelarmen bzw. Schenkeln aufweisendes Hebelsystem. Anders als beim Erfindungsgegenstand hängt die Symmetrie der Bewegung hierbei im wesentlichen von der Position zweier Stellschrauben ab. Montage und insbesondere der Justieraufwand sind erheblich. Auch die Herstellung einer solchen Blende ist kompliziert. Zur Bildung eines Pinholes sind vier präzise gefertigte Teile erforderlich, die bei Befestigung auf den Schenkeln zueinander genau justiert werden müssen. Die Kantenrauhigkeiten liegen selbst bei geläppten Kanten bei ca. 1µm. Geringere Rauhigkeiten erfordern einen sehr großen technologischen Aufwand.

Hier schafft die erfindungsgemäße Lösung Abhilfe.

Die Erfindung soll an Hand von Figuren erläutert werden. Es zeigen:
- Figur 1:: Wafer mit Nutzstrukturmaske
- Figur 2:: Verbundenes Spaltschneidenpaar
- Figur 3:: Spalt-Stelleinrichtung
- Figur 4:: Festkörperfedergelenk-Parallelogramm mit Piezoaktuator
- Figur 5:: Festkörperfedergelenk-Parallelogramm mit montierten Spaltschneidenträgern (Spalt-Stelleinrichtung)
- Figur 6:: Chippaar mit Pinholes und Justieröffnungen

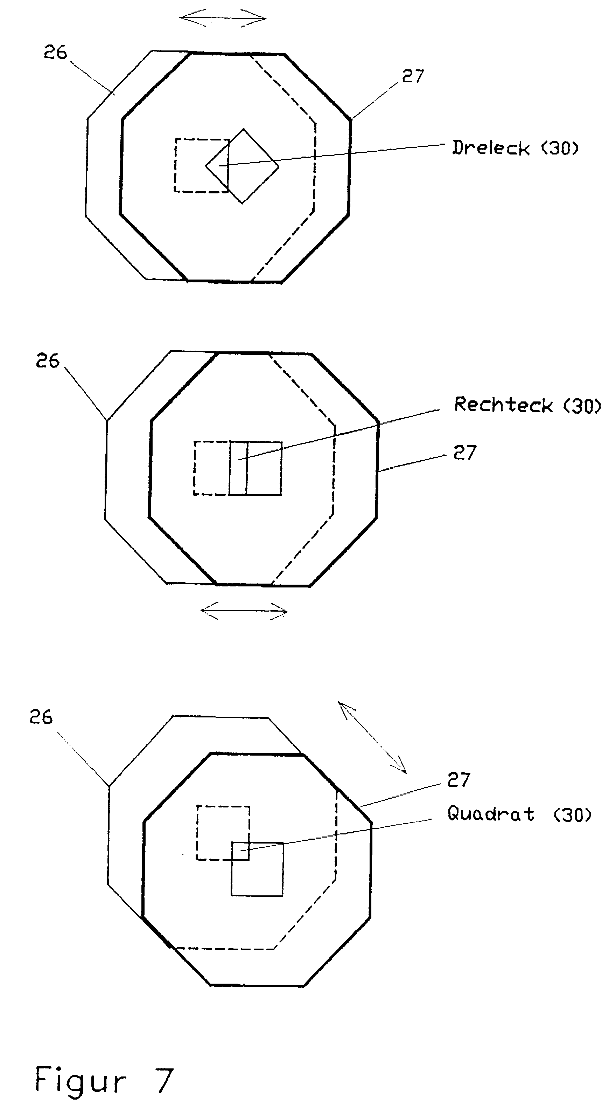

- Figur 7:: Zusammenwirken des Chippaares zur Erzeugung des variablen Pinholes
- Figur 8:: Querschnitt durch ein montiertes variables Pinhole.

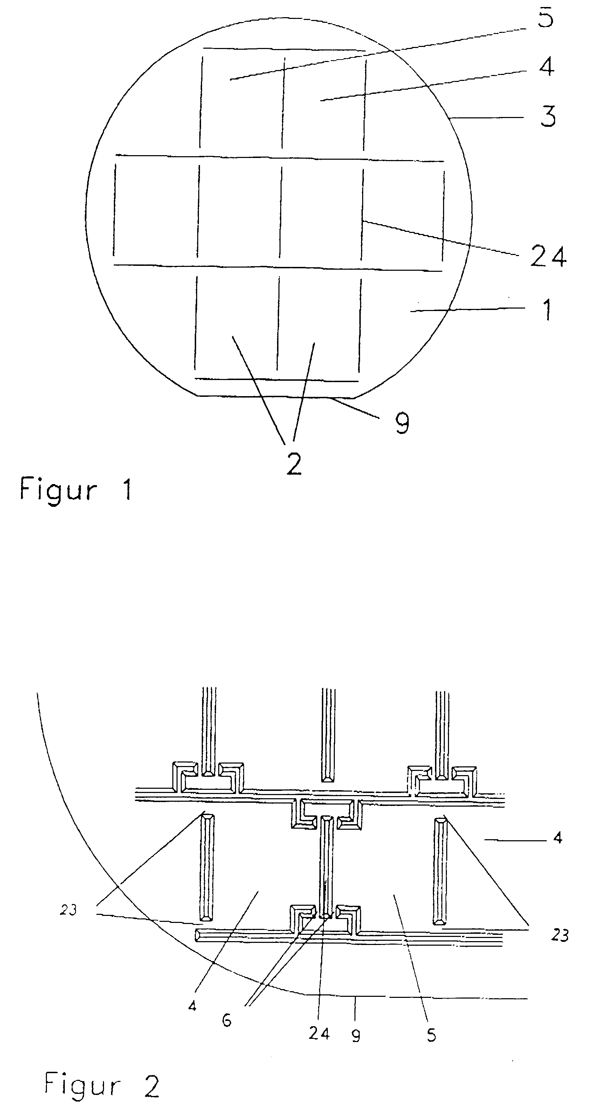

Figur 1 stellt einen Wafer 3 mit einer mikrolithographisch erzeugten Nutzstrukturmaske 1 dar. Auf ihm sind vier Spaltschneidenpaare 2 zu sehen, die untereinander durch Brücken 23 miteinander verbunden sind. Die Spaltschneiden 4 und 5 eines Spaltschneidenpaares 2 sind durch Stege 6 miteinander verbunden (Figur 2).

Als Ausgangsmaterial wird ein beidseitig polierter (110)-Silizium-Wafer 3 mit einer dünnen thermischen Oxidschicht (100 nm bis 300 nm), die mit einer CVD-Si₃N₄-Schicht (150 nm bis 200 nm) abgedeckt ist, eingesetzt. Darauf wird eine Resistschicht ausreichender Stärke aufgebracht.

Zuerst wird ein spezielles Justiermarkenfeld mit Ätzstrukturen fotolithographisch auf der beschichteten Waferoberfläche erzeugt. Die Vororientierung des Justiermarkenfeldes erfolgt nach der Wafer-Hauptphase 9 (primary flat). Nach dem Übertragen des Justierfeldes mittels Trockenätzen in die Nitrid- bzw. Oxidschicht wird die Resistmaske mit den üblichen Verfahren entfernt und der Wafer 3 in basischer Lösung, z.B . 30% KOH, geätzt. Es bilden sich typische Unterätzungen der Ätzstrukturen heraus, die mit Hilfe eines Meßmikroskopes auf Symmetriemerkmale untersucht werden. Die notwendige Justierung der Nutzstrukturmaske 1 zu der Kristallorientierung des Wafers 3 wird ermittelt.

Der Wafer 3 wird ein zweites Mal mit einem Resist beschichtet. Die Nutzstrukturmaske 1 wird in der ermittelten Lage auf den beschichteten Silizium-Wafer 3 durch Belichten übertragen. Analog zu dem Ätzen der Justiermarken erfolgt die Strukturübertragung in den Wafer 3.

Der Ätzprozeß erzeugt in einem Arbeitsgang gleichzeitig die als Spalt wirkende Schneidengeometrie in nahezu idealer Art und Weise und die Kontur der Schneide.

In einem im wesentlichen standardisierten mikrolithographischen Prozeß werden die Spaltschneidenpaare 2 erzeugt, die in hoher Güte zueinander passen.

Der Ätzprozeß wird gestoppt, wenn der Grund des Spaltes 24 des Spaltschneidenpaares 2 etwa 100 µm breit ist.

Nach dem vorsichtigen Abspülen des geätzten Wafers 3 wird dieser getrocknet und in die Spaltschneidenpaare 2 vereinzelt, indem die Brücken 23 durchbrochen werden. Die zusammengehörigen Schneiden 4 und 5 bilden ein auch nach dem Ätzprozeß noch verbundenes Spaltschneidenpaar 2. Damit ist eine vorteilhafte Handhabung beim Ätzen, zur Lagerung und zur Montage gewährleistet.

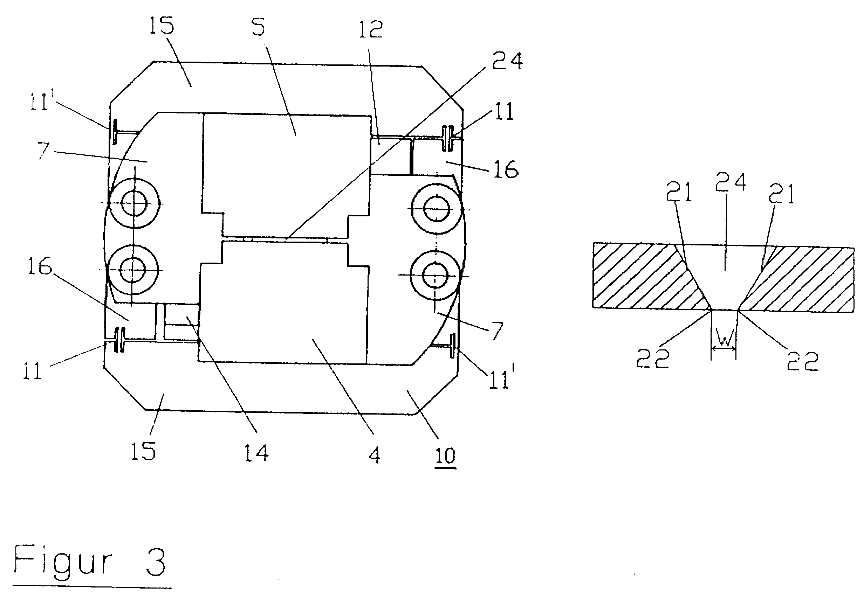

In der mit Stegen 6 gebundenen Form wird das Spaltschneidenpaar 2 auf die Spalt-Stelleinrichtung 8 montiert. Vorteilhatterweise erfolgt die Montage des Spaltschneidenpaares 2 auf speziell angefertigten Spaltschneidenträgern 7, die nach der Montage auf Schenkeln 16 der Spalt-Stelleinrichtung 8 gemeinsam plangeschliffen worden sind (Figur 3).

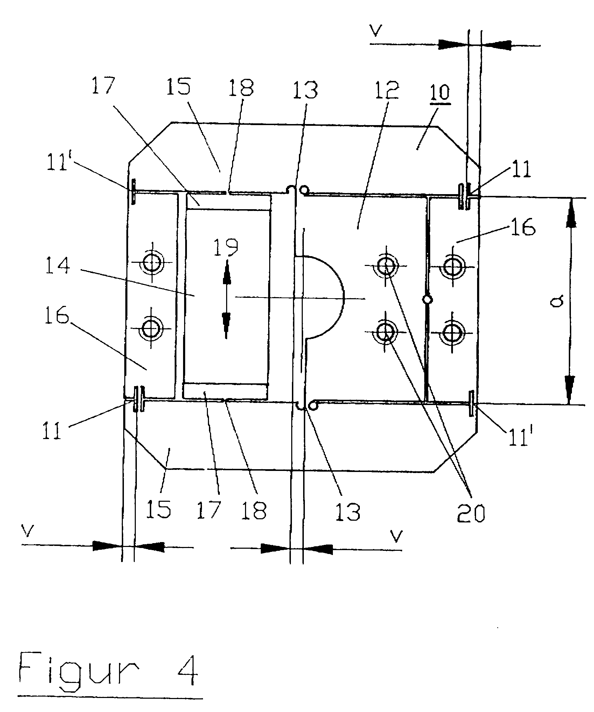

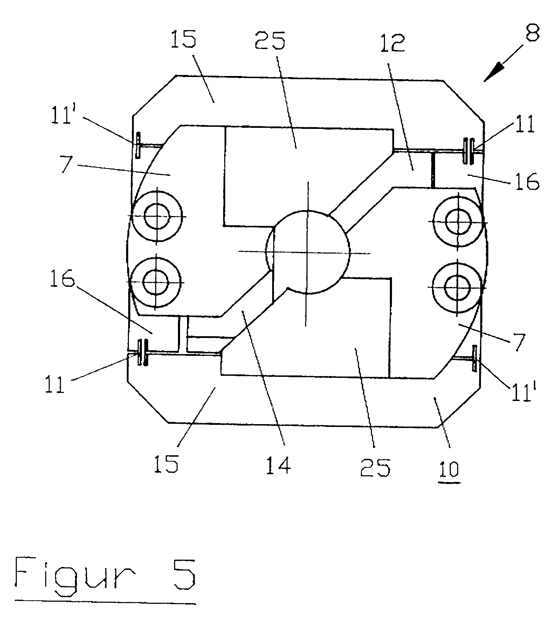

Der Aufbau der Spalt-Stelleinrichtung 8 ist aus Figur 4 und Figur 5 zu ersehen.

Die Befestigung des Ventils erfolgt an Gewindebohrungen 20 einer Befestigungsplatte 12. An dieser Befestigungsplatte 12 ist das Festkörperfedergelenk-Parallelogramm 10, bestehend aus zwei ersten Schenkeln 15 und zwei zweiten Schenkeln 16, durch zwei Gelenke 13 befestigt. Diese Gelenke 13 besitzen einen Versatz V, der mit der Länge a das Übersetzungsverhältnis der Piezoakuator-Längenänderung in eine Änderung der Weite des Spaltes w bestimmt.

Die Eckpunkte des Festkörperfedergelenk-Parallelogramms 10 bilden Federgelenke 11 und 11'. Die Federgelenke 11 und 11' sind um den gleichen Versatz V gegeneinander verschoben. Damit liegt ein Parallelogramm vor, welches um die Gelenke 13 drehbar ist. Das Parallelogramm wird durch einen piezoelektrischen Aktuator 14 betätigt. Dieser Piezoaktuator 14 wiederum ist mit seinen Endflächen an beweglichen Aufnahmetellern 17 befestigt. Die beweglichen Aufnahmeteller 17 sind über Gelenke 18 mit den ersten Schenkeln 15 des Festkörperfedergelenk-Parallelogramms 10 verbunden. Durch diese Maßnahme werden die bei Ansteuerung des Piezoaktuators 14 entstehenden Drehmomente aufgenommen. Wird der Piezoaktuator 14 mit einer elektrischen Spannung angesteuert, so dehnt er sich in seiner Länge und dies bewirkt eine Drehung des Festkörperfedergelenk-Parallelogrammes 10 um die Gelenke 13 und damit eine Vergrößerung der Hauptdiagonalen zwischen den Federgelenken 11' der Hauptdiagonalen und eine Verkürzung der Nebendiagonalen mit den Federgelenken 11 der Nebendiagonalen.

Durch das Übersetzungsverhältnis ü wird der Hub des Piezoaktuators 14 um den Multiplikationsfaktor ü vergrößert. An den Schenkeln 16 werden die Schneidenträger 7 durch Schrauben befestigt.

Die so entstandene Anordnung ist in Figur 5 dargestellt. Auf Montageflächen 25 werden das Spaltschneidenpaar 2 (die durch Stege verbundenen Spaltschneiden 4 und 5) vorzugsweise durch Aufkleben befestigt.

Werden die noch durch die Stege 6 verbundenen Schneiden 4 und 5 auf den Spaltschneidenträgern 7 bei einer bestimmten, konstanten Steuerspannung des Piezoaktuators (Vorspannung) befestigt und dann die Steuerspannung weiter erhöht, brechen die Stege 6 durch die steigende Zugspannung.

Die Stege 6 haben die Spaltschneiden 4 und 5 bis zu diesem Zeitpunkt zusammengehalten. Durch diese Maßnahme war eine einfache Manipulation und Montage der Spaltschneiden möglich. Im spannungslosen Zustand gehen die Spaltschneiden in ihre "Null"-Stellung.

In der Darstellung nach Figur 5 werden bei Ansteuerung des Aktuators 14 die Spaltschneiden 4 und 5 voneinander weg bewegt, die Öffnungsweite w des Spaltes wird vergrößert.

Wird die Spalt-Stelleinrichtung 8 in der Art gedreht, daß die Unterseite zur Oberseite wird, so werden die montierten Spaltschneidenträger 7 und damit die Spalt-Schneiden 4 und 5 aufeinander zu bewegt. Dadurch besteht die Möglichkeit, mit der gleichen Spalt-Stelleinrichtung 8 einen aktiv geschlossenen Spalt 24 und einen aktiv geöffneten Spalt 24 zu realisieren.

Die Größe der Steuerspannung des Piezoaktuators 14 bestimmt die Öffnungsweite w des Spaltes. Der Hub der Spalt-Stelleinrichtung 8 und damit die vorliegende Spaltweite ist langzeitig konstant, reproduzierbar oder mit zeitlicher Dynamik der Spaltweitenänderung einstellbar.

Da der piezoelektrische Aktuator 14 eine hystereseförmige Kennlinie besitzt, in automatisierten Systemen jedoch häufig ein linearer Zusammenhang zwischen Steuer- und gesteuerter Größe erwünscht ist, ist es vorteilhaft, in die Spalt-Stelleinrichtung 8 ein Wegmeßsystem als IST-Wertgeber einzubauen. Dieses kann z.B. ein kapazitives- oder induktives- oder auch ein optisches Wegmeßsystem sein. Wird dieses an den Spaltschneidenträgern 7 befestigt und an dieser Stelle die Wegänderung der Spaltschneidenträger 7 bezüglich der Befestigungsplatte 12 gemessen, so können alle Driften, Instabilitäten und Nichtlinearitäten, die in dem System auftreten, durch einen elektronischen Regelkreis minimiert werden.

Die Herstellung der variablen Pinholes erfolgt vollkommen analog zu der Technologie, die für den variablen Spalt beschrieben wurde.

Durch die Kombination zweier fester Pinholes 28 geeigneter Größe und entsprechender Spalt-Stelleinrichtung 8 werden variable Pinholes 30 erzeugt.

Aus dem Wafer 3 werden Pinholepaare, bestehend aus einem ersten Chip 26 und einem zweiten Chip 27, die durch Stege 6 miteinander verbunden sind, hergestellt.

Jedes Chip 26, 27 hat vorzugsweise eine achteckige Umrandung mit gleichen Seitenlängen und gleichen eingeschlossenen Winkeln. Im Zentrum eines jeden Chips 26, 27 befindet sich das aus im Winkel zueinander stehenden Schneidkanten 22 gebildete Pinhole 28. Die im Winkel zueinander stehenden Schneidkanten 22 bilden ein Vieleck, vorzugsweise durch das Kristallgitter bestimmt, ein Rechteck.

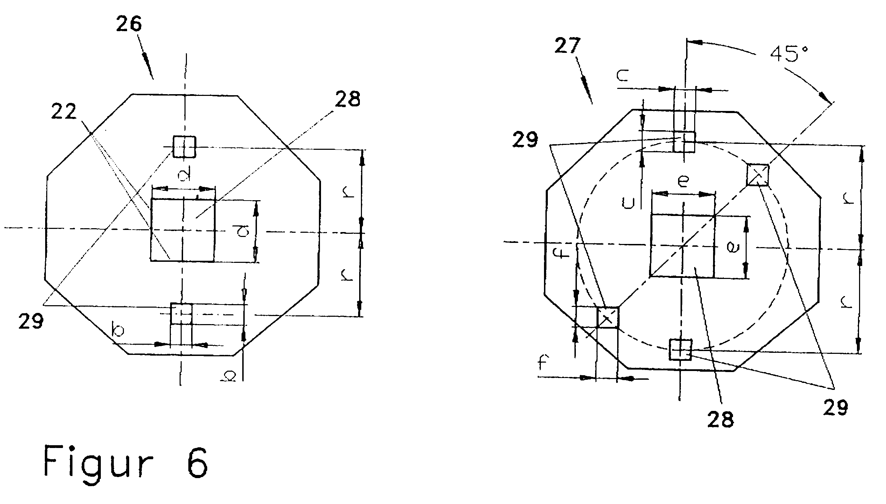

Die Kantenlängen d, e der vorzugsweise quadratischen Pinholes 28 sind je nach Anwendung verschieden groß gewählt und können bei einem Pinholepaar auch unterschiedlich groß sein. Zusätzlich zu dem Pinhole 28 mit der Kantenlänge d befinden sich auf dem ersten Chip 26 noch zwei quadratische Justieröffnungen 29 mit den Kantenlängen b. Ihre Kanten liegen parallel zu Schneidenkanten 22 des Pinholes 28. Die Zentren der Justieröffnungen 29 und das Zentrum des Pinholes 28 liegen auf einer Linie im Abstand r voneinander entfernt, wobei die Linie parallel zu Schneidkanten 22 verläuft. Auf dem zweiten Chip 27 befinden sich das zentrisch angeordnete Pinhole 28 mit der Kantenlänge e und vier Justieröffnungen 29, von denen zwei mit den Kantenlängen c wie beim ersten Chip 26 angeordnet sind und die zwei anderen Justieröffnungen 29 unter Beibehaltung des Abstandes r und der Ausrichtung ihrer Kanten mit Kantenlängen f parallel zu Schneidkanten 22 auf der Verlängerung der Pinholediagonalen liegen (Figur 6).

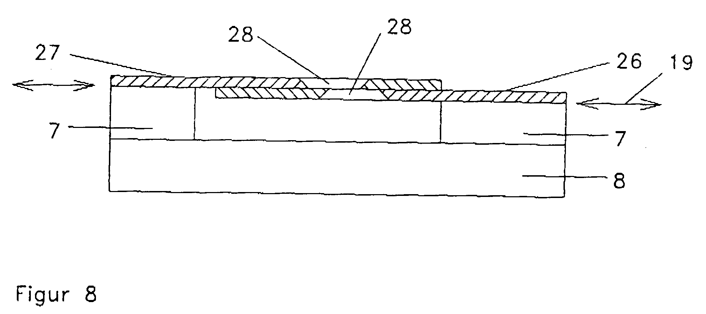

Die Montage der Chips 26, 27 erfolgt gemäß Figur 8 so, daß das erste Chip 26 mit der kleineren Pinholeöffnung, d.h. mit der Schneidenseite, nach oben auf einen Spaltschneidenträger 7 aufgeklebt wird, wobei mit den Justieröffnungen eine Ausrichtung bezüglich der Bewegungsrichtung 19 erfolgt. Das zweite Chip 27 wird so auf den anderen Spaltschneidenträger 7 geklebt, daß sich die Zentren der Pinholes 28 übereinander auf einer Linie befinden und die Justieröffnungewn 29 beider Chips 26, 27 zur Deckung kommen.

Je nach gewünschter Pinhole-Form kommen die auf der Diagonalen liegenden Justieröffnungen für dreieckförmige variable Pinholes 30 oder die anderen Justieröffnungen 29 für rechteckförmige variable Pinholes 30 zum Einsatz. Bei der Montage ist das Anlegen einer Vorspannung zur Öffnung der Spalt-Stelleinrichtung 8 auf die halbe Öffnungsweite w/2 des Spaltes 24 sinnvoll. Die Spaltschneidenträger 7 werden vor der Montage der Chips 26, 27 so geschliffen, daß die Montagefläche 25 in zwei parallele Ebenen mit einem Höhenversatz, der der Waferdicke entspricht, liegen. Das erste Chip 26 wird auf die tieferliegende Montagefläche 25 gebracht.

Eine Pinhole-Anordnung kann weiterhin dadurch realisiert werden, daß mehrere gleichartige Spalt-Stelleinrichtungen 8 mit aufmontierten Spaltschneiden 4,5 (mit geraden Schneidkanten 22) übereinandergestapelt werden. Die jeweiligen Bewegungsrichtungen 19 sind um die Stapelachse verdreht.

Es entsteht bei z.B. zwei Spaltantrieben, die um 90 Grad verdreht sind, ein variables rechteckförmiges Pinhole. Durch mehrere Spalte 24, die verdreht übereinander angeordnet sind, entsteht ein variables Vieleck oder eine lrisblende. Eine Abbildung der Schneidkanten 22 der verschiedenen Spalt-Stelleinrichtungen 8 aufeinander ist vorteilhaft.

Wird in dem Festkörperfedergelenk-Parallelogramm 10 der Spalt-Stelleinrichtung 8 der Piezoaktuator 14 mit dem Versatz V schräg in das Festkörperfedergelenk-Parallelogramm 10 eingebaut, ergeben sich die gleichen Verhältnisse für das Übersetzungsverhältnis und die Bewegung der Spaltschneiden 4,5 auf den Spaltschneidenträgern 7, wie beim schiefen Festkörperfedergelenk-Parallelogramm 10 mit um den Betrag V versetzten Federgelenkpunkten 11, 11' und Gelenkpunkten 13.

## Patentansprüche

1. Verstellbare Blende, bestehend aus zwei gegenüberliegenden, um ihre Mitte drehbar gelagerten ersten Schenkeln sowie zwei gegenüberliegenden zweiten Schenkeln, die über Gelenke mit den ersten Schenkeln unter Bildung eines Parallelogramms verbunden sind und die jeweils eine Spaltschneide eines Spaltschneidenpaares tragen, sowie aus einer Betätigungseinrichtung mittels der die Form des Parallelogramms gegen die Wirkung einer Rückstellkraft und damit der Abstand der Spaltschneiden veränderbar ist,
dadurch gekennzeichnet,
daß die Betätigungseinrichtung aus einem Piezoaktuator (14) besteht, der zwischen den ersten beiden Schenkeln (15) seitlich beabstandet von den Lagerpunkten (13) dieser Schenkel (15) angeordnet ist und an diesen ersten Schenkeln angreift, und daß benachbarte erste und zweite Schenkel (15, 16) über Festkörperfedergelenke (11, 11') miteinander verbunden sind, wobei sämtliche Gelenkpunkte (11, 11', 13) des einen der ersten Schenkel (15) gegenüber denjenigen des anderen ersten Schenkels (15) quer zur Bewegungsrichtung (19) des Piezoaktuators (14) um einen Betrag (V) versetzt sind.

2. Verstellbare Blende, bestehend aus zwei gegenüberliegenden um ihre, Mitte drehbar gelagerten ersten Schenkeln sowie zwei gegenüberliegenden zweiten Schenkeln, die über Gelenke mit den ersten Schenkeln unter Bildung eines Parallelogramms verbunden sind und die jeweils eine Spaltschneide eines Spaltschneidenpaares tragen, sowie aus einer Betätigungseinrichtung mittels der die Form des Parallelogramms gegen die Wirkung einer Rückstellkraft und damit der Abstand der Spaltschneiden veränderbar ist,
dadurch gekennzeichnet, daß benachbarte erste und zweite Schenkel (15, 16) über Festkörperfedergelenke (11,11') miteinander verbunden sind; und
daß die Betätigungseinrichtung aus einem Piezoaktuator (14) besteht, der zwischen den ersten beiden Schenkeln (15) schräg angeordnet ist und derart an diesen ersten Schenkeln angreift, daß der Angriffspunkt der einem Endfläche des Piezoaktuators (14) gegenüber dem Ansgriffspunkt der anderen Endfläche am jeweiligen Schenkel (15) bezüglich der jeweiligen Gelenkpunkte (13) um einen Betrag (V) versetzt ist.

3. Verstellbare Blende nach Anspruch 1 oder 2,
dadurch gekennzeichnet,
daß der Piezoaktuator (14) mit seinen Endflächen auf Aufnahmetellern (17) aufliegt, welche jeweils über ein Gelenk (18) mit einem der ersten Schenkel (15) verbunden sind.

4. Verstellbare Blende nach Anspruch 1 oder 2,
dadurch gekennzeichnet,
daß für Pinhole-Anwendungen jede der Spaltschneiden (4, 5) mit zumindest zwei im Winkel zueinander stehenden Schneidkanten (22) versehen ist.

5. Verstellbare Blende nach Anspruch 4,
dadurch gekennzeichnet,
daß die Schneidkanten (22) einer jeden Spaltschneide (26, 27) eine rechteckige Öffnung bilden.

6. Verstellbare Blende nach Anspruch 5,
dadurch gekennzeichnet,
daß eine der beiden Spaltschneiden (26, 27) gegenüber der anderen Spaltschneide (26 bzw. 27) um einen Winkel verdreht auf dem zweiten Schenke (16) angeordnet ist, derart, daß im Zusammenwirken der Spaltschneiden (26, 27) ein dreieckförmiges Pinhole (30) bildbar ist.

7. Verstellbare Blende nach zumindest einem der Ansprüche 1 bis 6,
dadurch gekennzeichnet,
daß die Spaltschneiden (4, 5; 26, 27) aus einem naß- oder trockenätzbaren, einkristallinen Material bestehen und entlang einer ausgewählten Kristallgitterrichtung verlaufende Schneidkanten (22) aufweisen.

8. Verstellbare Blende nach Anspruch 7,
dadurch gekennzeichnet,
daß die Spaltschneiden (4, 5; 26, 27) aus einkristallinem Silizium gefertigt sind.

9. Verstellbare Blende nach zumindest einem der Ansprüche 1 bis 8,
dadurch gekennzeichnet,
daß die Spaltschneiden (4, 5; 26, 27) zumindest im Bereich ihrer Schneidkanten (22) mit einem Metall-, Kunststoff-, Keramik- oder einem anderen geeigneten Überzug versehen sind.

10. Verstellbare Blende nach zumindest einem der Ansprüche 1 bis 9,
dadurch gekennzeichnet,
daß zur Messung der Spaltweite ein Wegmeßsystem angeordnet ist.

11. Verstellbare Blende nach zumindest einem der vorhergehenden Ansprüche,
dadurch gekennzeichnet,
daß mehrere, jeweils mit einer Spaltstelleinrichtung (8) versehene Spaltschneidenpaare (4, 5; 26, 27) in Ebenen parallel zueinander derart übereinander gestapelt sind, daß im Zusammenwirken der Spaltstelleinrichtungen (8) eine gewünschte Öffnungsgeometrie, z.B. ein 8-Eck, entsteht.

12. Verfahren zur Herstellung einer piezoelektrisch verstellbaren Blende, die aus einer Spalt-Stelleinrichtung mit einem Piezoaktuator und mindestens einem Spaltschneidenpaar besteht,
mit dem Verfahrens schritten,
daß zunächst zumindest zwei durch Stege(6) miteinander verbundene Spaltschneiden (4, 5) hergestellt werden, wobei die Kontur der Spaltschneiden (4, 5) mittels Mikrolitographie in eine sich auf einem Wafer (3) befindende Resistmaske geschrieben und mittels mindestens eines Ätzprozesses in den Wafer (3) übertragen wird,
daß ferner ein aus zwei ersten gegenüberliegenden Schenkeln (15) und zwei zweiten gegenüberliegenden Schenkeln (16) bestehendes, durch vier Federgelenke (11, 11') miteinander verbundenes Festkörperfedergelenk-Parallelogramm (10) vorgefertigt wird, dessen erste Schenke (15) mittels Gelenken (13) in einer Befestigungsplatte (12) drehbar gelagert sind, und daß sodann der Piezoaktuator (14) außermiffig zwischen den ersten Schenkeln (15) angeordnet wird und
daß danach die durch Stege (6) verbundenen Spaltschneiden (4,5) zunächst als einteiliges Spaltschneidenpaar (2) auf den zweiten Schenkeln (16) montiert werden und
daß nach Herstellung der festen Verbindung zwischen Spaltschneidenpaar (2) und Spalt-Stelleinrichtung (8) durch erstmaliges Auslenken des Piezoaktuators (14) das Spaltschneidenpaar (2) durch Brechen der Stege (6) in die Spaltschneiden (4,5) vereinzelt wird.

13. Verfahren nach Anspruch 12,
wobei
als Material für den Wafer (3) einkristallines Silizium verwendet wird.

14. Verfahren nach Anspruch 12 oder 13,
wobei
die Lage der Struktur einer Nutzstrukturmaske (1) zur Kristallorientierung des Materials des Wafers (3) dadurch bestimmt wird, daß zunächst mit Hilfe von Justiermarken eine Probeätzung durchgeführt, das Ergebnis nach Symmetriemerkmalen beurteilt und danach die Lage der Nutzstrukturmaske (1) zu einer ausgewählten Kristallgitterrichtung des Wafers (3) ausgerichtet wird.

15. Verfahren nach Anspruch 14,
wobei
die Nutzstrukturmaske (1) zum Wafer (3) so ausgerichtet wird, daß eine Kristallgitterrichtung des Materials, welche die Spur einer die Waferoberfläche schneidenden [1 1 1]-Fläche ist, mit der Richtung einer Schneidkante (22) der Spaltschneide (4,5) weitestgehend übereinstimmt.

16. Verfahren nach Anspruch 12,
wobei
das Festkörperfedergelenk-Parallelogramm (10) aus einem Stück eines massiven, elektrisch leitfähigen Materials durch Elektroerosion gefertigt wird.

17. Verfahren nach Anspruch 16,
wobei
das Festkörperfedergelenk-Parallelogramm (10) aus Edelstahl gefertigt wird.

18. Verfahren nach zumindest einem der Ansprüche 12 bis 17,
wobei
auf den zweiten Schenkeln (16) des Festkörperfedergelenk-Parallelogramms (10) zunächst vorgefertigte, mit Montageflächen (25) für die Spaltschneiden (4, 5) versehene Spaltschneidenträger (7) befestigt werden, anschließend Planparallelität der Montageflächen (25) durch wenigstens einen Schleifvorgang hergestellt wird und erst danach die Spaltschneiden (4, 5) auf den Montageflächen (25) montiert werden.

19. Verfahren nach zumindest einem der Ansprüche 12 bis 18,
wobei
die Spaltschneiden (4, 5) durch Aufkleben befestigt werden.

## Claims

1. Adjustable diaphragm consisting of two opposite first legs supported for pivoting about their centre, and of two opposite second legs, which are articulated to said first legs so as to form a parallelogram and whereof each carries a slit jaw of a pair of slit jaws, and of an actuating means permitting the control of the shape of the parallelogram in opposition to the effect of a resetting force and hence the spacing between said slit jaws,
**characterized in**
that said actuating means consists of a piezo actuator (14) which is disposed between said first two legs (15) at a lateral spacing from the support points (13) of these legs, (15), so as to act upon these first legs, and
in that adjacent first and second legs (15, 16) are interconnected by means of solid resilient joints (11, 11'), with all points of articulation (11, 11', 13) of one of said first legs (15) being opposite to the points of the other first leg (15) with an offset by an amount (V) transversely to the direction of movement (19) of said piezo actuator (14).

2. Adjustable diaphragm consisting of two opposite first legs supported for pivoting about their centre, and of two opposite second legs, which are articulated to said first legs so as to form a parallelogram and whereof each carries a slit jaw of a pair of slit jaws, and of an actuating means permitting the control of the shape of the parallelogram in opposition to the effect of a resetting force and hence the spacing between said slit jaws,
**characterized in**
that adjacent first and second legs (15, 16) are articulated to each other by means of solid resilient joints (11, 11'), and
that said actuating means consists of a piezo actuator (14) which is disposed askew between said first two legs (15) for acting on these first legs such that the point of application of one of the end faces of said piezo actuator (14), opposite to the point of application of the other end surface at the respective leg (15), is offset by an amount (V) relative to the respective points of articulation (13).

3. Adjustable diaphragm according to Claim 1 or 2,
**characterized in**
that said piezo actuator (14) is supported by its end faces on receiving disks (17) which are each articulated by means of a respective articulation (18) to one of said first legs (15).

4. Adjustable diaphragm according to Claim 1 or 2,
**characterized in**
that for pinhole applications each of said slit jaws (4, 5) is provided with at least two jaw edges (22) disposed in a mutual angular relationship.

5. Adjustable diaphragm according to Claim 4,
**characterized in**
that said jaw edges (22) of each of said slit jaws (26, 27) form a rectangular aperture.

6. Adjustable diaphragm according to Claim 5,
**characterized in**
that one of said two slit jaws (26, 27) is disposed on said second leg (16) in a position rotated through an angle relative to the other one of said slit jaws (26 or 27, respectively) so as to allow for a triangular pinhole (30) by the interaction between said slit jaws (26, 27).

7. Adjustable diaphragm according to at least any of Claims 1 to 6,
**characterized in**
that said slit jaws (4, 5; 26, 27) are made of a monocrystalline material suitable for wet or dry etching, and present jaw edges (22) extending along a selected direction of the crystal lattice.

8. Adjustable diaphragm according to Claim 7,
**characterized in**
that said slit jaws (4, 5; 26, 27) are made of monocrystalline silicon.

9. Adjustable diaphragm according to at least any of Claims 1 to 8,
**characterized in**
that said slit jaws (4, 5; 26, 27) are provided, at least in the area of their jaw edges (22), with a metal, resin, ceramic coating or a coating of any other suitable material.

10. Adjustable diaphragm according to at least any of Claims 1 to 9,
**characterized in**
that a displacement measuring system is arranged for measuring the slit width.

11. Adjustable diaphragm according to at least any of the preceding Claims,
**characterized in**
that several pairs of slit jaws (4, 5; 26, 27) are stacked on each other in parallel planes, with each pair being provided with a slit control means (8), so as to form a desired aperture geometry, e.g. an octogon, by the interaction of said slit control means (8).

12. Method of producing an adjustable diaphragm by a piezoelectric process, which is constituted by a slit control means with at least one piezo actuator, and by at least one pair of slit jaws, **comprising** the following steps of operation:
that initially at least two slit jaws (4, 5) are produced, which are interconnected by means of lands (6), with the contour of said slit jaws (4, 5) being traced by micro-lithographic means in a photoresist mask applied on a wafer (3), and transferred by at least one etching process into said wafer (3),
that moreover a solid spring joint parallelogram (10) is prefabricated, which is formed by two first opposite legs (15) and two second opposite legs (16) which are interconnected by means of four resilient joints (11, 11'), whereof said first legs (15) are pivotable in a mounting plate (12) by means of articulations (13), and
that then said piezo actuator (14) is eccentrically arranged between said first legs (15), and
then said slit jaws (4, 5) interconnected by lands (6), are initially mounted as integral pair of slit jaws (2) on said second legs (16), and
that following the establishment of the fixed connection between said pair of slit jaws (2) and said slit control means (8), said piezo actuator (14) is deflected for the first time so as to separate said pair of slit jaws (2) into said slit jaws (4, 5) by breaking said lands (6).

13. Method according to Claim 12,
wherein
monocrystalline silicon is used as wafer (3) material.

14. Method according to Claim 12 or 13,
wherein
the position of the structure of an effective pattern mask (1) for the crystalline orientation of the wafer (3) material is determined by an initial trial etching process by means of alignment targets, by the evaluation of the result by symmetry characteristics, whereupon the position of said effective pattern mask (1) is aligned relative to a selected direction of the crystal lattice of said wafer (3).

15. Method according to Claim 14,
wherein
said effective pattern mask (1) is aligned relative to said wafer (3) such that a direction of the crystal lattice of the material, which constitutes the trace of a [1 1 1] surface intersecting with the wafer surface, is congruent with the direction of a jaw edge (22) of said slit jaw (4, 5) as largely as possible.

16. Method according to Claim 12,
wherein
said solid spring joint parallelogram (10) is made by electroerosive machining from one piece of a solid electrically conductive material.

17. Method according to Claim 16,
wherein
said solid spring joint parallelogram (10) is made of stainless steel.

18. Method according to at least any of Claims 12 to 17,
wherein
initially prefabricated jaw mounts (7) provided with mounting surfaces (25) for said slit jaws (4, 5) are fastened on said second legs (16) of said solid spring joint parallelogram (10), and subsequently plane parallelism of said mounting surfaces (25) is established by at least one grinding process, whereupon only then said slit jaws (4, 5) are mounted on said mounting surfaces (25).

19. Method according to at least any of Claims 12 to 18,
wherein
said slit jaws (4, 5) are adhesively fastened.

## Revendications

1. Diaphragme réglable, formé par deux premières branches opposées, pivotantes autour de leur centre, ainsi que par deux deuxièmes branches opposées, reliées, moyennant des joints, auxdites premières branches en formant un parallélogramme, dont chacune porte une arête de fente d'une paire d'arêtes de fente, ainsi que par un moyen de commande, qui permet le réglage de la forme du parallélogramme en opposition à l'action d'une force de rappel, et ainsi de l'écart entre lesdites arêtes de fente,
**caractérisé en ce**
que ledit moyen de commande est constitué par un organe final piézoélectrique (14) qui est disposé entre lesdites premières deux branches (15), à un écart latéral des points d'appui (13) de ces branches (15), en agissant sur ces premières branches, et en ce que des premières et deuxièmes branches voisines (15, 16) sont articulées l'une à l'autre moyennant des joints élastiques solides (11, 11'), tous les points d'articulation (11, 11', 13) de l'une desdites premières branches (15) étant opposés aux points de l'autre première branche (15) en déport par un montant (V) transversalement au sens de mouvement (19) dudit organe final piézoélectrique (14).

2. Diaphragme réglable, formé par deux premières branches opposées, pivotantes autour de leur centre, ainsi que par deux deuxièmes branches opposées, reliées, moyennant des joints, auxdites premières branches en formant un parallélogramme, dont chacune porte une arête de fente d'une paire d'arêtes de fente, ainsi que par un moyen de commande, qui permet le réglage de la forme du parallélogramme en opposition à l'action d'une force de rappel, et ainsi de l'écart entre lesdites arêtes de fente,
**caractérisé en ce**
que en ce que des premières et deuxièmes branches voisines (15, 16) sont articulées l'une à l'autre moyennant des joints élastiques solides (11, 11'), et
en ce que ledit moyen de commande est constitué par un organe final piézoélectrique (14) qui est disposé en biais entre lesdites premières deux branches (15) et agit sur ces premières branches de façon que le point d'application de l'une des surfaces terminales dudit organe final piézoélectrique (14), en face du point d'application de l'autre surface terminale à la branche respective (15), se trouve en déport par un montant (V) relativement aux points d'articulation respectifs (13).

3. Diaphragme réglable selon la revendication 1 ou 2,
**caractérisé en ce**
que ledit organe final piézoélectrique (14) s'appuie, par ses surfaces terminales, sur des disques de logement (17), dont chacune est articulée, moyennant une articulation (18) respective, à une desdites premières branches (15).

4. Diaphragme réglable selon la revendication 1 ou 2,
**caractérisé en ce**
que pour des applications à ouvertures *pinholes,* chacune desdites arêtes de fente (4, 5) est prévue d'au moins deux tranchants (22) disposés à un angle l'un relativement à l'autre.

5. Diaphragme réglable selon la revendication 4,
**caractérisé en ce**
que lesdits tranchants (22) de chacune desdites arêtes de fente (26, 27) forment une ouverture rectangulaire.

6. Diaphragme réglable selon la revendication 5,
**caractérisé en ce**
qu'une desdites deux arêtes de fente (26, 27) est disposée sur ladite deuxième branche (16) en position tordue par un angle, relativement à l'autre desdites arêtes de fente (26 ou respectivement 27), de façon à permettre une ouverture *pinhole* triangulaire (30) par l'interaction desdites arêtes de fente (26, 27).

7. Diaphragme réglable selon au moins une quelconque des revendications 1 à 6,
**caractérisé en ce**
que lesdites arêtes de fente (4, 5; 26, 27) sont faites en une matière monocristalline et apte à être gravée par voie humide ou sèche, et présentent des tranchants (22) qui s'étendent le long d'un sens choisi du réseau cristallin.

8. Diaphragme réglable selon la revendication 7,
**caractérisé en ce**
que lesdites arêtes de fente (4, 5; 26, 27) sont faites en silicium monocristallin.

9. Diaphragme réglable selon au moins une quelconque des revendications 1 à 8,
**caractérisé en ce**
que lesdites arêtes de fente (4, 5; 26, 27) sont prévues, au moins dans la zone de leurs tranchants (22), d'un revêtement métallique, aux résines synthétiques, céramique ou en toute autre matière appropriée.

10. Diaphragme réglable selon au moins une quelconque des revendications 1 à 9,
**caractérisé en ce**
qu'un système de mesure de déplacement est disposé à mesurer la largeur de la fente.

11. Diaphragme réglable selon au moins une quelconque des revendications précédentes,
**caractérisé en ce**
que plusieurs paires d'arêtes de fente (4, 5; 26, 27), dont chacune est prévue d'un moyen à régler la fente (8), sont empilées l'une sur l'autre dans des plans parallèles l'un à l'autre, de façon à former une géométrie souhaitée de l'ouverture, par exemple un octogone, par l'interaction desdits moyens à régler la fente (8).

12. Procédé à fabriquer un diaphragme réglable par voie piézoélectrique, qui est composé d'un moyen à régler la fente, à au moins un organe final piézoélectrique, et d'au moins une paire d'arêtes de fente,
**comprenant** les opérations suivantes:
fabrication initiale d'au moins deux arêtes de fente (4, 5) reliées l'une à l'autre moyennant des entretoises (6), le contour desdites arêtes de fente (4, 5) étant tracé, par voie micro-lithographique, dans une cache en photorésist appliquée sur une galette (3), et transféré, par au moins un processus de gravure, dans ladite galette (3),
de plus la préfabrication d'un parallélogramme de joint élastique solide (10) composé de deux premières branches (15) opposées et deux deuxièmes branches (16) opposées, qui sont articulées, l'une à l'autre, moyennant quatre joints élastiques (11, 1l'), dont lesdites premières branches (1 5) sont pivotantes dans une plaque de fixation (12) moyennant des articulations (13), et
ensuite l'arrangement excentrique dudit organe final piézoélectrique (14) entre lesdites premières branches (15), et
ci-après le montage initial desdites arêtes de fente (4, 5) reliées par des entretoises (6), comme paire d'arêtes de fente (2) en une partie, sur lesdites deuxièmes branches (16), et
après l'établissement de la liaison fixe entre ladite paire d'arêtes de fente (2) et ledit moyen à régler la fente (8), une première déviation dudit organe final piézoélectrique (14), en rompant lesdits entretoises (6), afin de déparier ladite paire d'arêtes de fente (2) dans lesdites arêtes de fente (4, 5).

13. Procédé selon la revendication 12,
dans lequel
de silicium monocristallin est utilisé comme matière de la galette (3).

14. Procédé selon la revendication 12 ou 13,
dans lequel
la position de la structure d'une cache de structure utile (1) pour l'orientation des monocristaux de la matière de la galette (3) est déterminée par une opération de gravure d'épreuve initiale, en utilisant des repères d'ajustage, par l'évaluation du résultat selon des caractéristiques de symétrie, et ensuite par l'alignement de la position de ladite cache de structure utile (1) sur un sens choisi du réseau cristallin de la galette (3).

15. Procédé selon la revendication 14,
dans lequel
ladite cache de structure utile (1) est alignée sur ladite galette (3) de façon, qu'un sens du réseau cristallin de la matière, qui constitue la trace d'une surface [1 1 1], qui coupe la surface de la galette, soit en conformité la plus large possible avec le sens d'un tranchant (22) de ladite arête de fente (4, 5).

16. Procédé selon la revendication 12,
dans lequel
ledit parallélogramme de joint élastique solide (10) est fait par électro-érosion d'une pièce d'une matière électroconductrice massive.

17. Procédé selon la revendication 16,
dans lequel
ledit parallélogramme de joint élastique solide (10) est fait d'acier spécial allié.

18. Procédé selon au moins une quelconque des revendications 12 à 17,
dans lequel
des éléments porte-arêtes (7) préfabriqués et prévus des aires de montage (25) pour lesdites arêtes de fente (4, 5) sont attachés d'abord sur lesdites deuxièmes branches (16) dudit parallélogramme de joint élastique solide (10), et un état à faces planes et parallèles desdits aires de montage (25) est ensuite établi par au moins une opération de rectification, et seulement ci-après lesdites arêtes de fente (4, 5) sont montées sur lesdites aires de montage (25).

19. Procédé selon au moins une quelconque des revendications 12 à 18,
dans lequel
lesdites arêtes de fente (4, 5) sont attachées par collage.
